# EUROPEAN PATENT APPLICATION

(11) **EP 2 857 195 A1**
(43) Date of publication of application: **08.04.2015**
(21) Application number: 13796263.5
(22) Date of filing: 31.05.2013
(51) Int. Cl.: B32B 27/08, B32B 27/16, H01L 31/042

(54) **MULTILAYER FILM AND PHOTOVOLTAIC MODULE COMPRISING SAME**

(30) Priority: 31.05.2012 KR 20120058829
(71) Applicant: LG Chem, Ltd., Seoul 150-721 (KR)
(72) Inventor: KWON, Yoon Kyung, Daejeon 305-738 (KR); KIM, Hyun Cheol, Daejeon 305-738 (KR)
(74) Representative: Goddar, Heinz J.
(86) International application number: PCT/KR2013/004842
(87) International publication number: WO 2013/180532

(57) **Abstract**

Provided is a multilayered film having excellent reliability and adhesive strength under a heat/water resistance condition, and excellent weather resistance and durability by forming a primer layer including a fluoropolymer and an oxazoline group-containing polymer on a base and forming a resin layer including a fluoropolymer on the primer layer. In addition, the multilayered film uses a low boiling point solvent, and thus is manufactured at a low drying temperature and with a low cost, resulting in reducing production costs and preventing degradation of quality of a product from thermal deformation or thermal impact. Such a multilayered film may be effectively used in a backsheet for a photovoltaic module to provide a photovoltaic module capable of maintaining excellent durability even in long-term exposure to an external environment.

## Description

### CROSS-REFERENCE TO RELATED APPLICATION

This application claims priority to and the benefit of Korean Patent Application No. 2012-0058829, filed May 31, 2012 and Korean Patent Application No. 2013-0062615, filed May 31, 2013, the disclosure of which is incorporated herein by reference in its entirety.

### TECHINICAL FIELD

The present application relates to a multilayered film, a method of manufacturing the same, a backsheet for a photovoltaic cell including the same, and a photovoltaic module.

### BACKGROUD ART

Today, attention to new regenerable and clean energy is increasing due to environmental problems of the Earth and the depletion of fossil fuels, and among such energy, solar energy has attracted attention as a representative nonpolluting energy source capable of resolving the problems of environmental pollution and depletion of fossil fuels.

A photovoltaic cell to which a solar power generating principle is applied is a device converting solar light into electric energy, which is exposed to an external environment for a long time to facilitate absorption of the solar light. Therefore, the photovoltaic cell is formed in the form of a unit by performing various packaging to protect the cell, and the unit is called a photovoltaic module.

Generally, the photovoltaic module uses a backsheet having excellent weather resistance and durability to stably protect the photovoltaic cell even when exposed to an external environment for a long time. As such a backsheet, one that is prepared by stacking a resin layer including a fluoropolymer such as polyvinyl fluoride (PVF) on a base is generally used.

However, the PVF resin does not have a high adhesive strength to a polyethylene terephthalate (PET) film representatively used as a base for a backsheet, and therefore a fluoropolymer film obtained by extrusion or casting is used by being laminated on the base using a urethane-based adhesive. However, to this end, expensive equipment for manufacturing a film and an adhesive are needed, and adhesive coating and lamination processes are additionally needed. In addition, a thicker film than that required for film handleability in the process of manufacturing a film is needed, various additives and fillers are limitedly used, and a high process temperature is required.

Moreover, when the resin layer including a fluoropolymer is formed into a resin suspension or solution, coated on a base and dried, since a solvent having a high boiling point is generally used, a high drying temperature of 200°C or more is needed. To provide such a high drying temperature, a great amount of energy is needed, which causes an increase in production costs for a backsheet of a photovoltaic module and induces a thermal shock or thermal deformation, resulting in degradation in quality such as a mechanical property of a product and rapid degradation in mechanical property in long-term use in an external environment.

Accordingly, there is a continuous demand for a material for a backsheet for a photovoltaic cell which has a high adhesive strength to a base, has excellent durability and weather resistance, and is dried at a low drying temperature, thereby reducing production costs of the backsheet for a photovoltaic cell and enhancing productivity and quality of a photovoltaic module.

### SUMMARY OF THE INVENTION

The present application is directed to providing a multilayered film having an excellent interlayer adhesive strength, weather resistance, and durability, a method of manufacturing the same, a backsheet for a photovoltaic module, and a photovoltaic module including the same.

In one aspect, the present application provides a multilayered film, which includes a base, a primer layer which is includes a fluoropolymer and a polymer containing an oxazoline group and which is formed on the base, and a resin layer which includes a fluoropolymer and which is formed on the primer layer.

In another aspect, the present application provides a method of manufacturing a multilayered film, which includes forming a primer layer including a fluoropolymer and an oxazoline group-containing polymer on a base; and forming a resin layer including a fluoropolymer on the primer layer.

In still another aspect, the present application provides a backsheet for a photovoltaic module including a multilayered film according to exemplary embodiments of the present application.

In yet another aspect, the present application provides a photovoltaic module including a backsheet for a photovoltaic module according to the present application.

### BRIEF DESCRIPTION OF THE DRAWINGS

FIG. 1 is a cross-sectional view of a multilayered film according to an exemplary embodiment of the present application;
FIG. 2 is a cross-sectional view of a photovoltaic module according to an exemplary embodiment of the present application; and
FIG. 3 shows a cross-sectional view of a photovoltaic module according to another exemplary embodiment of the present application.

### DETAILED DESCRIPTION OF EXEMPLARY EMBODIMENTS

Hereinafter, exemplary embodiments of the present application will be described in detail. However, the present application is not limited to the exemplary embodiments disclosed below, but can be implemented in various forms. The following embodiments are described in order to enable those of ordinary skill in the related art to embody and practice the present application.

One exemplary embodiment of the present application relates to a multilayered film, which includes a base, a primer layer formed on the base which includies a fluoropolymer and an oxazoline group-containing polymer and which is formed on the base, and a resin layer which includes a fluoropolymer and which is formed on the primer layer.

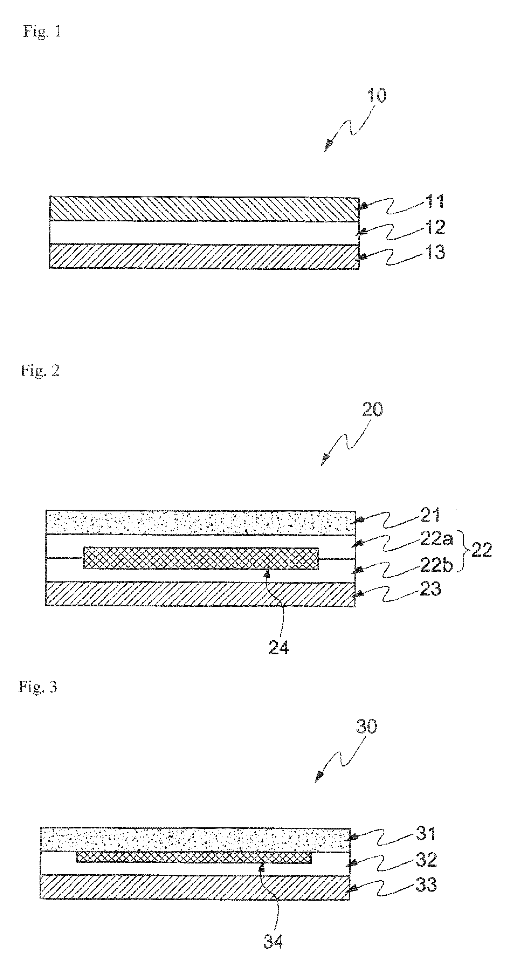

FIG. 1 is a cross-sectional view of a multilayered film according to an exemplary embodiment of the present application. As shown in FIG. 1, the multilayered film 10 includes a base 13, a primer layer 12 formed on the base 13, and a resin layer 11 formed on the primer layer 12. The primer layer 12 includes a fluoropolymer and an oxazoline group-containing polymer, and the resin layer 11 includes a fluoropolymer. A film (not shown) according to another embodiment of the present application may include a primer layer and a resin layer on the other surface of the base, resulting in forming the primer layers and the resin layers on both surfaces of the base.

A specific kind of the base included in the multilayered film is not particularly limited, and various materials known in the art may be used and suitably selected according to a required function or use.

In one example of the present application, the base may be any kind of a metal film or polymer film. Here, the metal film may be formed of a conventional metal component according to its use, and may be, but is not limited to, a single sheet, stacked sheet, or coextrusion product of an acryl film, a polyolefin film, a polyamide film, a polyurethane film, or a polyester film, and preferably a polyester film. The polyester film may be, but is not limited to, at least one selected from the group consisting of a polyethylene terephthalate (PET) film, a polyethylene naphthalate (PEN) film, and a polybutylene terephthalate (PBT) film.

In addition, as the polyester film, one having excellent hydrolysis resistance may be used, and the film having excellent hydrolysis resistance may be manufactured or selected from commercially available products. In one example, the polyester film having excellent hydrolysis resistance may have a small content of oligomers generated in condensation polymerization. In addition, by further performing a known thermal treatment to enhance hydrolysis resistance on the polyester film, a water content of polyester and a contraction rate may be reduced, thereby having better hydrolysis resistance.

To further enhance an adhesive strength with the primer layer including a fluoropolymer and an oxazoline group-containing polymer to be described later, a surface treatment such as high-frequency spark discharging treatment such as corona or plasma treatment; thermal treatment; flame treatment; treatment with an anchor agent; treatment with a coupling agent; treatment with a primer; or chemical activation using a gas-phase Lewis acid (ex. BF₃), sulfuric acid, or high-temperature sodium hydroxide may be performed on one or both surfaces of the base. The above surface treatment method may be performed by all kinds of known means generally used in the art. Through the surface treatment, a carboxyl group, an aromatic thiol group, and a phenol hydroxyl group are induced, thereby enhancing bindability with an oxazoline group included in the primer layer, and further enhancing a binding strength between the base and the primer layer.

In addition, in an aspect of further enhancing a water barrier characteristic, an inorganic oxide deposition layer may be formed on one or both surfaces of bases according to exemplary embodiments of the present application. The kind of the inorganic oxide is not particularly limited, and any one having a water barrier characteristic, for example, silicon oxide or aluminum oxide may be employed without limitation. Here, a method of forming an inorganic oxide deposition layer on one or both surfaces of the base may be a deposition method generally used in the art without particular limitation. In one example of the present application, when an inorganic oxide deposition layer is formed on one or both surfaces of the base, the above-described surface treatment may be performed on the deposition layer after the inorganic oxide deposition layer is formed on a surface of the base. That is, in one embodiment of the present application, to further enhance an adhesive strength to the deposition layer formed on the base, the above-described spark discharging treatment; flame treatment; treatment with a coupling agent; treatment with an anchor agent; or chemical activation may be performed.

A thickness of the base may be, but is not particularly limited to, for example, approximately 50 to 500 µm or 100 to 300 µm. By controlling the thickness of the base within the above range, electric insulability, a water barrier property, a mechanical characteristic, and handleability may be enhanced. However, the thickness of the base according to exemplary embodiments of the present application is not limited to the above range, and it may be controlled according to necessity.

The multilayered film according to exemplary embodiments of the present application includes a primer layer formed on the base, and the primer layer includes a primer layer including a fluoropolymer and an oxazoline group-containing polymer. Since the multilayered film includes the primer layer including a fluoropolymer and an oxazoline group-containing polymer, an adhesive strength between the base and the resin layer including a fluoropolymer may be enhanced. That is, the primer layer including a fluoropolymer and an oxazoline group-containing polymer may enhance the adhesive strength to the base due to an oxazoline group and a binding strength with the resin layer including a fluoropolymer due to dispersion of the fluoropolymer, and thus serve to strongly bind the base with the resin layer including the fluoropolymer. Accordingly, compared with when the primer layer does not include a fluoropolymer, it has less limitation to a fluoropolymer capable of being used in the fluorine-based resin layer on the primer layer.

The kind of the oxazoline group-containing polymer included in the primer layer is not particularly limited, and any one having excellent compatibility with the fluoropolymer is possibly used without limitation. In exemplary embodiments of the present application, the oxazoline group-containing polymer may be a homopolymer of an oxazoline group-containing monomer, a copolymer including a monomer containing an oxazoline group and at least one comonomer, or a mixture thereof, but the present application is not limited thereto.

The oxazoline group-containing monomer may be a compound represented by Formula 1:

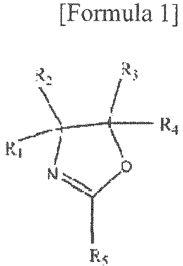

In Formula 1, R₁, R₂, R₃, and R₄ represent each independently a hydrogen atom, an alkyl group, a halogen, or a substituted or unsubstituted phenyl group, and R₅ represents a non-cyclic hydrocarbon group having an unsaturated bond.

In the substituted or unsubstituted phenyl group, as a substituent, at least one selected from the group consisting of an amino group, a methyl group, a chloromethyl group, and a chloro group may be used.

In addition, as the non-cyclic hydrocarbon group having an unsaturated bond, an alkenyl group, alkynyl group, or olefin group possibly participating in radical polymerization may be used, but the present application is not limited thereto.

The alkenyl group may have, for example, 1 to 12 or 1 to 5 carbon atoms, the alkynyl group may have, for example, 1 to 12 or 1 to 5 carbon atoms, and the olefin group may have, for example, 1 to 12 or 1 to 5 carbon atoms, but the present application is not limited thereto.

Specifically, the compound represented by Formula 1 may be, but is not limited to, at least one selected from the group consisting of 2-vinyl-2-oxazoline, 2-vinyl-4-methyl-2-oxazoline, 2-vinyl-5-methyl-2-oxazoline, 2-isoprophenyl-2-oxazoline, 2-isoprophenyl-4-methyl-2-oxazoline, and 2-isoprophenyl-5-ethyl-2-oxazoline.

In addition, in the copolymer including an oxazoline group-containing monomer and at least one comonomer, an oxazoline group-containing monomer may be included at 1 wt% or more, 5 to 95 wt%, or 10 to 90 wt% with respect to a total weight of the copolymer. In the copolymer including the oxazoline group-containing monomer and at least one comonomer, as the content of the oxazoline group-containing monomer is controlled within the range of 1 wt% or more, the adhesive strength with the base may be further enhanced.

The kind of a comonomer included in the copolymer including an oxazoline group-containing monomer and at least one comonomer in a polymerized form is not particularly limited, and the comonomer may be any one capable of being copolymerized with an oxazoline group-containing monomer without reacting with an oxazoline group.

The comonomer may be, but is not limited to, at least one selected from the group consisting of an alkyl (meth)acrylate, an amide group-containing monomer, an unsaturated nitrile-based monomer, a vinyl ester-based monomer, a vinyl ether-based monomer, a halogen-containing α,β-unsaturated monomer, and an α,β-unsaturated aromatic monomer.

The alkyl (meth)acrylate may have an alkyl group having 1 to 14 carbon atoms to provide balanced compatibility with the fluoropolymer and an excellent pressure-sensitive adhesive property, and may be at least one selected from the group consisting of methyl(meth)acrylate, ethyl(meth)acrylate, propyl(meth)acrylate, n-butyl(meth)acrylate, s-butyl(meth)acrylate, t-butyl(meth)acrylate, isobutyl(meth)acrylate, hexyl(meth)acrylate, 2-ethylhexyl(meth)acrylate, n-octyl(meth)acrylate, isooctyl(meth)acrylate, n-nonyl(meth)acrylate, isononyl(meth)acrylate, n-decyl(meth)acrylate, isodecyl(meth)acrylate, n-dodecyl(meth)acrylate, n-tridecyl(meth)acrylate, and n-tetradecyl(meth)acrylate.

In addition, the amide group-containing monomer may be (meth)acrylamide, diethylacrylamide, N-vinylpyrrolidone, N,N-dimethyl(meth)acrylamide, N,N-diethyl(meth)acryl amide, N,N'-methylenebisacrylamide, N,N-dimethylaminopropylacrylamide, N,N-dimethylaminopropylmethacrylamide, diacetone(meth)acrylamide, or methylol(meth)acrylamide, the unsaturated nitrile monomer may be (meth)acrylonitrile, ethacrylonitrile, phenylacrylonitrile, or α-chloroacrylonitrile, the vinyl ether monomer may be vinyl acetate or vinyl propionate, the vinyl ether monomer may be methyl vinyl ether or ethyl vinyl ether, the halogen-containing α,β-unsaturated monomer may be vinyl chloride, vinylidene chloride, or vinyl fluoride, and the α,β-unsaturated aromatic monomer may be styrene or α-methylstyrene, but the present application is not limited thereto.

The oxazoline group-containing polymer may have a weight average molecular weight of, for example, 5,000 to 500,000, 10,000 to 250,000, or 20,000 to 150,000, but the present application is not particularly limited thereto. As the weight average molecular weight of the oxazoline group-containing polymer is controlled within the above range, suitable compatibility with a fluoropolymer and/or flowability may be ensured, thereby providing an adhesive strength.

A method of polymerizing the oxazoline group-containing polymer is not particularly limited, and may be a known method such as solution polymerization, emulsion polymerization, bulk polymerization, or suspension polymerization. In addition, a copolymer obtained thereby may be any one of a random copolymer, a block copolymer, an alternate copolymer, or a graft copolymer. In the art, various methods of preparing the oxazoline group-containing polymer are known, and all the methods may be applied.

The multilayered film according to exemplary embodiments of the present application includes a resin layer formed on the primer layer and including a fluoropolymer.

In the multilayered film having the above structure, the fluoropolymer included in the primer layer may penetrate into the resin layer including the fluoropolymer on the primer layer together with the polymer containing an oxazoline group, and the fluoropolymer included in the resin layer also penetrate into the primer layer, thereby forming an interpenetrating polymer network (IPN).

In one embodiment, a C-F₂ bond dipole of the fluoropolymer included in the primer layer or resin layer may induce an interaction by a van der Waals bond with an oxazoline group contained in the oxazoline group-containing polymer or another functional group, for example, an ester group, and thus an interface adhesive strength at a contact interface may be further enhanced.

A content of the oxazoline group-containing polymer included in the primer layer may be 5 to 100, 10 to 95, 20 to 80, 40 to 100, or 50 to 95 parts by weight based on the fluoropolymer of the primer layer, and in this range, the polymer has an excellent adhesive strength.

The kind of fluoropolymer included in the primer layer may be the same as or different from that of the resin layer formed thereon, and various additives may be further included when necessary.

The kind of fluoropolymer included in the primer layer and the resin layer is not particularly limited, and may be, for example, a homopolymer, copolymer, or mixture thereof including at least one monomer selected from the group consisting of vinylidene fluoride (VDF), vinyl fluoride (VF), tetrafluoroethylene (TFE), hexafluoropropylene (HFP), chlorotrifluoroethylene (CTFE), trifluoroethylene, hexafluoroisobutylene, perfluorobutylethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxole (PDD), and perfluoro-2-methylene-4-methyl-1,3-dioxolane (PMD) in a polymerized form.

In addition, the fluoropolymer included in the primer layer and the resin layer may be a homopolymer or copolymer including VDF in a polymerized form, a homopolymer or copolymer including VF in a polymerized form, or a mixture of at least two thereof.

Here, the kind of comonomer included in the copolymer in a polymerized form may be, but is not particularly limited to, at least one selected from the group consisting of tetrafluoroethylene (TFE), hexafluoropropylene (HFP), chlorotrifluoroethylene (CTFE), trifluoroethylene, hexafluoroisobutylene, perfluorobutylethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxol (PDD), and perfluoro-2-methylene-4-methyl-1,3-dioxolane (PMD), and in one example, at least one of hexafluoropropylene and chlorotrifluoroethylene, but the present application is not limited thereto.

A content of the comonomer included in the copolymer may be, but is not particularly limited to, for example, approximately 0.5 to 50 wt%, 1 to 40 wt%, 7 to 40 wt%, 10 to 30 wt%, or 10 to 20 wt% based on a total weight of the copolymer. As the content of the comonomer is controlled within the above range, durability and weather resistance of the multilayered film may be ensured, effective inter-diffusion and low temperature drying may be induced, and the adhesive strength may be further enhanced.

The fluoropolymer included in the primer layer and the resin layer may have a melting point of 80 to 175 °C or 120 to 165 °C. As the melting point of the fluoropolymer is controlled to 80 °C or more, a deformation of the multilayered film in use may be prevented, and as the melting point of the fluoropolymer is controlled to 175 °C or less, solubility with respect to a solvent may be controlled, and gloss of the coating surface may be enhanced.

Furthermore, the fluoropolymers included in the primer layer and the resin layer may include i) a first fluoropolymer having a melting point of 155 °C or less or a softening point of 100 °C or more. Since such a first fluoropolymer is easily mixed with another polymer in a high temperature coating process due to the low melting point and softening point, and increased in non-crystalline part, it has excellent compatibility with another polymer. Particularly, the first fluoropolymer may have a high mixing property with the oxazoline group-containing polymer, and high compatibility with the fluoropolymer of the resin layer including the fluoropolymer, thereby further enhancing the adhesive strength.

In addition, the fluoropolymer may further include ii) a second fluoropolymer having a melting point of 155 °C or more and a softening point of 100 °C or less, in addition to the first fluoropolymer, but the second fluoropolymer may be selectively used when necessary. The second fluoropolymer may have a melting point of more than 155 °C and a softening point of 100 °C or less.

All of the first and second fluoropolymers correspond to the fluoropolymer described above and are distinguished according to the melting point and the softening point, which are original characteristics of the polymer due to polymerization of the monomers forming the fluoropolymers. The first fluoropolymer having a melting point of 155 °C or less or a softening point of 100 °C or more may take up 20 wt% or more based on a total weight of the fluoropolymer included in the primer layer or resin layer, and when taking up 50 wt% or more, the interaction may be more preferable. Likewise, as the melting point or softening point of the fluoropolymer of the primer layer or the resin layer is controlled, the interaction with the resin layer including the fluoropolymer may be increased, and thus the adhesive strength may be further enhanced.

A weight average molecular weight of the fluoropolymers included in the primer layer and the resin layer may be 50,000 to 1,000,000, 100,000 to 700,000 or 300,000 to 500,000, but the present application is not limited thereto. The "weight average molecular weight" used herein is a conversion value of standard polystyrene measured by gel permeation chromatography (GPC). As the weight average molecular weight of the fluoropolymer is controlled within the above range, excellent solubility and other physical properties may be ensured.

A thickness of the primer layer including the fluoropolymer and the oxazoline group-containing polymer may be, but is not particularly limited to, 10 nm or more. As the thickness of the primer layer is controlled to 10 nm or more, the adhesive strength may be further enhanced. For example, the thickness of the primer layer may be 10 to 10,000 nm, 20 to 5,000 nm, or 50 to 2,000 nm, and as the thickness of the primer layer is controlled as described above, an adhesive strength of the primer layer is enhanced, and durability and weather resistance may be excellently maintained. However, the thickness of the primer layer according to exemplary embodiments of the present application is not limited to above-described range, and may be suitably controlled as needed.

The thickness of the resin layer including a fluoropolymer is not particularly limited, and may be, for example, 3 to 50 µm or 10 to 30 µm. As the thickness of the resin layer including a fluoropolymer is controlled within the above range, a light shielding property may be enhanced, and an increase in production costs may be prevented.

The resin layer including a fluoropolymer may further include a pigment or filler with a fluoropolymer to control a color or opacity or achieve other purposes. Here, the pigment or filler that can be used may be, but is not limited to, a metal oxide such as titanium dioxide (TiO₂), silica, or alumina; a black pigment such as calcium carbonate, barium sulfate, or carbon black; or a pigment component exhibiting a different color. The above pigment or filler may serve to further improve an adhesive strength of the resin layer by an original functional group included in each component together with an original effect of controlling a color or opacity of the resin layer.

A content of the additive such as a pigment or filler may be 200 wt% or less based on a solid content of the fluoropolymer, but the present application is not limited thereto.

The resin layer according to exemplary embodiments of the present application may further include a conventional component such as a UV stabilizer, a thermal stabilizer, or a barrier particle.

The resin layer including the primer layer and the fluoropolymer may be a coating layer. The term "coating layer" used herein refers to a resin layer formed by a coating method. More particularly, the "coating layer" refers to the above-described resin layer or primer layer including a fluoropolymer which is formed by coating a coating solution prepared by dissolving components constituting the resin layer in a solvent, for example, having a low boiling point on a base, not by laminating a sheet manufactured by a casting or extrusion method to the base using an adhesive.

The multilayered film according to exemplary embodiments of the present application may further include various functional layers known in the art as needed. The functional layer may be an adhesive layer or an insulating layer. In the multilayered film according to an exemplary embodiment of the present application, the above-described primer layer and resin layer including a fluoropolymer may be sequentially formed on one surface of the base, and an adhesive layer and an insulating layer may be sequentially formed on the other surface of the base. The adhesive layer or insulating layer may be formed by various methods known in the art. The insulating layer may be, for example, a layer formed of ethylene vinylacetate (EVA) or low-density linear polyethylene (LDPE). The layer formed of ethylene vinylacetate (EVA) or low-density linear polyethylene (LDPE) may simultaneously serve to increase an adhesive strength with an encapsulant of a photovoltaic module, enable to reduce production costs, and maintain excellent re-workability.

Other exemplary embodiments of the present application provides a method of manufacturing a multilayered film, which includes forming a primer layer including a fluoropolymer and an oxazoline group-containing polymer on a base, and forming a resin layer including a fluoropolymer on the primer layer.

The specific kind of the base is described above, on one or both surfaces of the base, at least one suitable surface treatment selected from the group consisting of deposition treatment, plasma treatment, corona treatment, treatment with an anchor agent, treatment with a coupling agent, treatment with a primer, and thermal treatment may be performed before the resin layer is formed, and the base on which at least one surface treatment layer is formed by performing the surface treatment may be used.

As described above, by performing at least one surface treatment on one or both surfaces of the base, a carboxyl group, an aromatic thiol group, and a phenol hydroxyl group may be induced to a surface of the base. The functional groups may form chemical covalent bonds with an oxazoline group included in the primer layer, thereby further enhancing interface binding strength between the base and the primer layer.

A method of forming the primer layer on the base is not particularly limited. For example, based on various methods known in the art, the primer layer is possibly formed by a method of coating a resin composition for forming a primer layer prepared by dissolving or dispersing the above-described fluoropolymer and oxazoline group-containing polymer in a suitable organic solvent such as ethanol or toluene or aqueous solvent such as water on the base, and drying the coating layer under a predetermined condition.

Here, the coating method is not particularly limited, and thus any method capable of forming an uniform primer layer including a known printing method such as offset printing or gravure printing, or a known coating method such as roll coating, knife edge coating, or gravure coating is possibly applied. Besides the method, various methods known in the art may be applied, and the resin composition for forming a primer layer may further include various additives as needed.

The resin composition for forming a primer layer may be prepared by dissolving or dispersing components for forming a primer layer in an aqueous solvent such as water or a solvent having a relatively low boiling point, particularly, a solvent having a boiling point of 200°C or less. Accordingly, in a manufacturing process according to exemplary embodiments of the present application, a high temperature drying process is not required, and thus production costs may be reduced and thermal deformation or thermal impact of the base capable of being caused by high temperature drying may be prevented, thereby enhancing a quality of the product.

The solvent having a relatively low boiling point may be, but is not limited to, at least one selected from the group consisting of acetone, methylethylketone (MEK), dimethylformamide (DMF) and dimethylacetamide (DMAC).

The solvent such as water, methylethylketone, dimethylformamide, or dimethylacetamide is a solvent evaporated at a temperature of 200°C or less, in which components for forming the primer layer including the fluoropolymer and oxazoline group-containing polymer may be easily dissolved, and dried at a relatively low temperature after being coated on the base.

A method of preparing the resin composition for forming a primer layer or a ratio of respective components included in the resin composition is not particularly limited, and various methods known in the art may be suitably employed.

In exemplary embodiments according to the present application, followed by an operation of coating the resin composition for forming a primer layer on the base, a process of drying the coated resin composition may be further performed. Dry conditions are not particularly limited, and for example, the drying process may be performed at 200 °C or less or 100 to 180 °C for 30 seconds to 30 minutes or 1 minute to 10 minutes. By performing the drying process in the above temperature range, an increase in production costs due to the high temperature drying process performed at 200 °C or more may be prevented, and degradation in product quality due to thermal deformation or thermal impact may be prevented.

Subsequently, in the operation of forming a resin layer including a fluoropolymer on a primer layer to manufacture a multilayered film, a method of forming the resin layer including a fluoropolymer on the primer layer is not particularly limited, and does not have a large difference from that of forming the primer layer. In the resin composition for forming the resin layer including the fluoropolymer, in addition to the fluoropolymer, various additives such as a pigment, a filler, a UV stabilizer, or a thermal stabilizer may be further included.

The additive may be dissolved in a solvent with the fluoropolymer, or prepared in a millbase type separate from the component and then mixed with a solvent including the fluoropolymer. A chemical interaction such as van der Waals bond, a hydrogen bond, an ionic bond, or a covalent bond may be generated, by a functional group included in an additive such as a filler or pigment dispersant capable of being included in the resin layer including the fluoropolymer, and thus an adhesive strength between the resin layer and the base may be further enhanced.

A method of preparing the resin composition for forming a resin layer including a fluoropolymer or a ratio of respective components in the resin composition is not particularly limited, and various methods known in the art may be suitably employed.

In exemplary embodiments according to the present application, followed by an operation of coating the resin composition for forming a resin layer on the primer layer, a process of drying the coated resin composition may be further performed. Conditions in the drying process are not particularly limited, and for example, the drying process may be performed at 200 °C or less or 100 to 180 °C for 30 seconds to 30 minutes or 1 minute to 10 minutes. Ay performing the drying process in the above temperature range, an increase in production costs due to the high temperature drying process performed at 200 °C or more may be prevented, and degradation in product quality due to thermal deformation or thermal impact may be prevented.

Still another embodiment of the present application relates to a backsheet for a photovoltaic module including a multilayered film according to the exemplary embodiments.

The backsheet for a photovoltaic module includes a primer layer including a fluoropolymer and an oxazoline group-containing polymer, which is formed on a base and a resin layer including a fluoropolymer formed on the primer layer, and an oxazoline group included in the oxazoline group-containing polymer forms a chemical covalent bond with various functional groups on a surface of the base, and thus an excellent adhesive strength between the base and the primer layer is provided. In addition, the fluoropolymer included in the primer layer interacts with the fluoropolymer included in the resin layer, thereby further enhancing an adhesive strength through a physical or chemical bond between the primer layer and fluoropolymer, and since only a fluoropolymer having excellent weather resistance is included in the outmost layer of the backsheet, durability and weather resistance may be enhanced.

Particularly, in the process of manufacturing a backsheet for a photovoltaic module, the fluoropolymer and oxazoline group-containing polymer included in the primer layer may be inter-diffused into the base or a surface treatment layer of the base at an interface between the primer layer and the base or between the primer layer and the surface treatment layer of the base, thereby forming a chemical covalent bond between the base and the primer layer, and enhancing an adhesive strength by chain entanglement and a van der Waals force between molecular chains. In addition, at the interface between the fluoropolymer layer and the primer layer, the fluoropolymer included in the resin layer may be inter-diffused into the primer layer, thereby enhancing an adhesive strength between the resin layer and the primer layer including the fluoropolymer by the chain entanglement and the van der Waals force between the molecular chains.

In addition, the backsheet for a photovoltaic module according to exemplary embodiments of the present application may have durability, weather resistance, insulability, and a water barrier property to stably protect a photovoltaic cell from long-term exposure to an external environment.

Yet another embodiment of the present application provides a photovoltaic module including a backsheet for a photovoltaic module according to the exemplary embodiments.

A structure of the photovoltaic module is not particularly limited as long as the module includes the multilayered film as a backsheet for a photovoltaic module, and various structures generally known in the art may be employed without limitation.

In one embodiment of the present application, a photovoltaic module may include a transparent front substrate, a backsheet, and a photovoltaic cell encapsulated by an encapsulant or a photovoltaic array disposed in series or parallel between the front surface and the backsheet. As an example, the structure of the photovoltaic module may include a backsheet, a photovoltaic cell or photovoltaic array formed on the backsheet, a light receiving sheet formed on the photovoltaic cell or photovoltaic array; and an encapsulant layer encapsulating the photovoltaic cell or photovoltaic array between the backsheet and the light receiving sheet.

As a backsheet, the multilayered film described above may be used, and a thickness of the backsheet may be, but is not particularly limited to, for example, 30 to 2,000 µm, 50 to 1,000 µm, or 100 to 600 µm. In the present application, as the thickness of the backsheet is controlled to 30 to 2.000 µm, a thinner photovoltaic module may be formed, and excellent physical properties such as weather resistance of the photovoltaic module may be maintained.

A specific kind of a photovoltaic cell formed on the backsheet is not particularly limited as long as it is capable of generating a photoelectro-motive force, and therefore a photovoltaic diode generally used in the related art may be used. In the present application, for example, a crystalline silicon photovoltaic cell, for example, using single crystal silicon or polycrystalline silicon, a single-bonded or tandem-structured amorphous silicon photovoltaic cell, a semiconductor photovoltaic cell including a III-V group compound such as gallium-arsenic (GaAs) or indium-phosphorus (InP), and a semiconductor photovoltaic cell including a II-VI group compound such as cadmium-tellurium (CdTe) or copper-indium-selenide (CuInSe₂) may be used, or a thin film polycrystalline silicon photovoltaic cell, a thin film non-crystalline silicon photovoltaic cell, and a hybrid photovoltaic cell of thin film crystalline silicon and amorphous silicon may be used.

The photovoltaic cell may form a photovoltaic array (photovoltaic collector) by interconnections between photovoltaic cells. When solar light is radiated to the photovoltaic module, electrons (-) and holes (+) are generated in a photovoltaic cell, thereby flowing a current through an interconnection between photovoltaic cells.

The light receiving sheet formed on the photovoltaic cell or photovoltaic array may protect an inside of the photovoltaic module from wind and rain, external impact, or fire, and may serve to ensure long-term reliability when the photovoltaic module is exposed to an external environment. A specific kind of the light receiving sheet is not particularly limited if it has excellent photo transmittance, electric insulability, and mechanical, physical, or chemical strength. For example, the light receiving sheet may be a glass plate, a fluorine-based resin sheet, a cyclic polyolefin-based resin sheet, a polycarbonate-based resin sheet, a poly(meth)acrylic resin sheet, a polyamide-based resin sheet, or a polyester-based resin sheet. In one exemplary embodiment of the present application, a glass plate having excellent thermal resistance may be used, but the present application is not limited thereto.

The light receiving sheet may have a thickness of, but not particularly limited to, for example, 0.5 to 10 mm., 1 to 8 mm., or 2 to 5 mm. As the thickness of the light-receiving substrate is controlled within a range of 0.5 to 10 mm, a thinner photovoltaic module may be formed, and excellent physical properties such as long-term reliability of the photovoltaic module may be maintained.

In addition, as the encapsulant layer encapsulating a photovoltaic cell or photovoltaic array in the photovoltaic module, particularly, between the backsheet and the light receiving sheet, an encapsulant generally known in the related art may be employed without limitation.

FIGS. 2 and 3 are cross-sectional views of photovoltaic modules according to various exemplary embodiments of the present application.

FIG. 2 is a cross-sectional view of a wafer-based photovoltaic module 20 including a backsheet for a photovoltaic module according to an exemplary embodiment of the present application. As shown in FIG. 2, the photovoltaic module according to an exemplary embodiment of the present application may include a light receiving sheet 21 capable of being conventionally formed of a ferroelectric (e.g., glass); the backsheet for a photovoltaic module 23 according to exemplary embodiments of the present application; a photovoltaic diode 24 of the silicon-based wafer; and an encapsulant layer 22 encapsulating the photovoltaic diode 24. Here, the encapsulant layer 22 may include a first layer 22a encapsulating the photovoltaic diode 24 and attached to the light receiving sheet 21, and a second layer 22b encapsulating the photovoltaic diode 24 and attached to the backsheet 23. The first and second layers constituting the encapsulant layer 22 may be formed of a material generally known in the related art as described above.

FIG. 3 is a cross-sectional view of a thin film-type photovoltaic module 30 according to another exemplary embodiment of the present application. As shown in FIG. 3, in the thin film-type photovoltaic module 30, a photovoltaic diode 34 may be formed on a light receiving sheet 31 capable of being generally formed of ferroelectrics. The thin film-type photovoltaic diode 34 may be conventionally deposited by chemical vapor deposition (CVD). The photovoltaic module 30 in FIG. 3 may include an encapsulant layer 32 and a backsheet 33, similar to the photovoltaic module 20 of FIG. 2, and the encapsulant layer 32 may be formed in a single layer. Details of the encapsulant layer 32 and the backsheet 33 are described above.

As the method of preparing a photovoltaic module, various methods known to those of ordinary skill in the related art may be employed without particular limitation.

The photovoltaic modules shown in FIGS. 2 and 3 are only examples of various exemplary embodiments of the photovoltaic modules of the present application. In case of including a backsheet for a photovoltaic module according to the present application, a structure of the module, and a kind and a size of a material constituting the module are not particularly limited, and those generally known in the related art may be employed without limitation.

### [Examples]

Hereinafter, the present application will be described in detail with reference to Examples according to the present application and Comparative Examples not according to the present application, but the scope of the present application is not limited to Examples to be described below.

Physical properties of films manufactured in Examples and Comparative Examples were measured by the following methods.

### 1. 180-degree peeling strength

Peeling strength was measured while a sample was cut to a width of 10 mm and peeled at a peeling rate of 4.2 mm/sec and a peeling angle of 180 degrees according to the specification ofASTM D1897.

### 2. Cross-hatch adhesive strength

A cross-cut test was performed according to the standard for a cross-cut test, that is, the specification of ASTM D3002/D3359. Specifically, a sample was cut at intervals of 1 mm in horizontal and vertical directions by 11 rows and columns using a knife, thereby forming a grid of 100 squares having a length and width of 1 mm×1 mm. Afterward, as a CT-24 adhesive tape produced by Nichiban was attached to the grid-formed surface and then detached, a state of the surface detached along with the tape was measured and evaluated according to the following criteria.

### <Criteria for Evaluating Cross-Hatch Adhesive Strength>

5B: no region is detached
4B: area of detached region is less than 5% based on total surface area
3B: area of detached region is from 5 to 15% based on total surface area
2B: area of detached region is from more than 15 to 35% based on total surface area
1B: area of detached region is from more than 35 to 65% based on total surface area
0B: almost all of the surface is detached

### 3. Pressure Cooker Test (PCT)

A change in adhesive strength was observed after each of multilayered films prepared in Examples and Comparative Examples in which both surfaces of a base were coated with a primer layer and a resin layer was left in an oven maintaining conditions of 2 atm, 121°C, and 100% R.H. for 25, 50, and 75 hours.

### <Preparation Example>

### Preparation of base

Corona treatment was performed on a surface of a PET film (thickness: 250 µm, produced by Kolon), which was not surface-treated.

### Preparation of fluoropolymer

Fluoropolymers used in Examples and Comparative Examples were prepared as shown in Table 1. In Table 1, monomer components and ratios of the fluoropolymers used in Examples and Comparative Examples, weight average molecular weight, melting points, softening points, and copolymerized types of the fluoropolymers are shown.

**[Table 1]**

| Fluoropolymer | | Monomer ratio (weight ratio) | Weight average molecular weight (M_{w}) | Melting point (°C) | Softening point (°C) |
|---|---|---|---|---|---|
| A | VDF-CTFE copolymer | 85:15(VDF:CTFE) | 270,000 | 168 | 80 |
| B | VDF-HFP copolymer | 85:15 (VDF:HFP) | 300,000 | 135 | 120 |
| C | VDF-CTFE copolymer | 80: 20(VDF:CTFE) | 270,000 | 168 | 75 |
| D | VDF-HFP copolymer | 88:12(VDF: HFP) | 500,000 | 135 | 120 |
| VDF: vinylidene fluoride | | | | | |
| CTFE: chlorotrifluoroethylene | | | | | |
| HFP: hexafluoropropylene | | | | | |

### <Example 1>

### Preparation of coating solution for forming fluoropolymer layer

100 g of a PVDF homopolymer was previously dissolved in 400 g of N,N-dimethyl formamide (DMF), thereby preparing a first coating solution.

Separate from the first coating solution, 0.9 g of BYK111 (BYK) as a pigment dispersant and 90 g of titanium dioxide (TiPure TS6200, Dupont) as a pigment were dissolved in 90 g of N,N-dimethyl formamide (DMF), 50 g of zirconia beads having a diameter of 0.3 mm was added and stirred at a speed of 1,000 rpm for 1 hour, and the beads were completely removed, thereby preparing 180.9 g of a millbase dispersion.

120.6 g of the prepared millbase dispersion (including 60 g of titanium dioxide) was added to the previously prepared first coating solution and stirred, thereby preparing a coating solution for forming a fluoropolymer layer.

### Preparation of primer coating solution

90 g of the fluoropolymer A (a copolymer including vinylidene fluoride (VDF) and chlorotrifluoroethylene (CTFE) in a weight ratio of 85:15 (VDF:CTFE) in a polymerized form) prepared in Preparation Example and 10 g of an oxazoline group-containing acrylic copolymer (WS-500, solid content: 40%, Nippon Shokubai Co., Ltd.) having a weight average molecular weight of 70,000 were previously dissolved in 400 g of N,N-dimethyl formamide (DMF), thereby preparing a primer coating solution.

### Coating and drying primer layer

The primer coating solution was coated on the previously prepared substrate using a Mayer's bar. Specifically, the coating solution was coated to have a thickness after drying of approximately 1000 nm, and the coated substrate passed through an oven having 120 meshes (mesh rate: 100%) and a length of 4 m at 120 °C at a rate of 3m/min, thereby forming a primer layer. Afterward, the coating solution was coated and dried by the same method as described above on the other side of the base, thereby forming a primer layer including a fluoropolymer and an oxazoline group-containing polymer on both surfaces of the PET film (base).

### Coating and drying of fluoropolymer layer

The coating solution for forming a fluoropolymer layer was coated on the primer layer by a comma reverse method. Particularly, the coating solution was coated to have a thickness after drying of approximately 20 µm, and the coated substrate sequentially passed through three ovens having a length of 2 m, in which temperatures were controlled to 80, 180, and 180 °C, respectively, at a speed of 1 m/min, thereby forming a resin layer. Afterward, the coating solution was coated and dried by the same method as described above on the other side of the base, thereby manufacturing a multilayered film in which the primer layer and the resin layer are sequentially formed on both surfaces of the PET film (base).

### <Example 2>

A multilayered film was manufactured by the same method as described in Example 1, except that a thickness of a primer layer after drying was changed to approximately 3000 nm.

### <Example 3>

A multilayered film was manufactured by the same method as described in Example 1, except that a thickness of a primer layer after drying was changed to approximately 5000 nm.

### <Example 4>

A multilayered film was manufactured by the same method as described in Example 1, except that a thickness of a primer layer after drying was changed to approximately 10000 nm.

### <Example 5>

A multilayered film was manufactured by the same method as described in Example 1, except that fluoropolymer B (a copolymer including VDF and HFP in a weight ratio of 85:15 (VDF:HFP) in a polymerized form) prepared in Preparation Example was used instead of the fluoropolymer for forming a primer layer.

### <Example 6>

A multilayered film was manufactured by the same method as described in Example 1, except that fluoropolymer C (a copolymer including VDF and CTFE in a weight ratio of 80:20 (VDF:CTFE) in a polymerized form) prepared in Preparation Example was used instead of the fluoropolymer for forming a primer layer.

### <Example 7>

A multilayered film was manufactured by the same method as described in Example 1, except that fluoropolymer D (a copolymer including VDF and HFP in a weight ratio of 88:12 (VDF:HFP) in a polymerized form) prepared in Preparation Example was used instead of the fluoropolymer for forming a primer layer.

### <Example 8>

A multilayered film was manufactured by the same method as described in Example 1, except that 45 g of the fluoropolymer A and 45 g of the fluoropolymer D were used instead of the fluoropolymer for forming a primer layer.

### <Example 9>

A multilayered film was manufactured by the same method as described in Example 1, except that 18 g of the fluoropolymer A and 72 g of the fluoropolymer D were used instead of the fluoropolymer for forming a primer layer.

### <Example 10>

A multilayered film was manufactured by the same method as described in Example 1, except that 18 g of the fluoropolymer A and 72 g of the fluoropolymer C were used instead of the fluoropolymer for forming a primer layer.

### <Example 11>

A multilayered film was manufactured by the same method as described in Example 1, except that 45 g of the fluoropolymer A and 55 g of the oxazoline group-containing acrylic copolymer were added in the preparation of a primer coating solution.

### <Comparative Example 1>

A commercially available stacked structure of a Tedlar film/adhesive%PET film/adhesive/Tedlar film was used as a multilayered film. The stacked structure is a product in which Tedlar films (PVF film (thickness: 38 µm) produced by Dupont through extrusion were laminated on both surfaces of a PET film using an adhesive.

### <Comparative Example 2>

A commercially available stacked structure of a Tedlar film/adhesive/PET film/adhesive/Tedlar film was used as a multilayered film. The stacked structure is a product in which Tedlar films (PVF film (thickness: 25 µm) produced by Dupont through casting were laminated on both surfaces of a PET film using an adhesive.

### <Comparative Example 3>

A multilayered film was manufactured by the same method as described in Example 1, except that an operation of forming a primer layer was omitted.

Components included in the primer layer of the multilayered films in Examples and Comparative Examples and contents thereof are shown in Table 2.

**[Table 2]**

| | Primer (resin composition) | | | |
|---|---|---|---|---|
| | Fluoropolymer / Content (g) | | WS-500 Content (g) | Primer layer thickness (nm) |
| Example | 1 | A: 90 g | 10 | 1000 |
| | 2 | A: 90 g | 10 | 3000 |
| | 3 | A: 90 g | 10 | 5000 |
| | 4 | A: 90 g | 10 | 10000 |
| | 5 | B: 90 g | 10 | 1000 |
| | 6 | C: 90 g | 10 | 1000 |
| | 7 | D: 90 g | 10 | 1000 |
| | 8 | A: 45 g, D: 45 g | 10 | 1000 |
| | 9 | A: 18 g, D: 72 g | 10 | 1000 |
| | 10 | A: 18 g, C: 72 g | 10 | 1000 |
| | 11 | A: 45 g, | 55 | 1000 |
| Comparative Example | 1 | Tedlar(Extrusion)/Adhesive/PET/Tedlar(Extrusion) | - | - |
| | 2 | Tedlar(Casting)/Adhesive/PET/Tedlar(Casting) | - | - |

### <Experimental Example 1>

PCT was performed to the multilayered films in Examples 1 to 11 and Comparative Examples 1 and 2, and then 180 degree peeling strength and cross-hatch tests were performed. Specifically, the multilayered film was left under the conditions of 2 atm, 121 °C, and 100% R.H. for 25, 50, and 75 hours, and then the 180 degree peeling strength and cross-hatch tests were performed to evaluate a change in adhesive strength. The evaluation results are shown in Table 3.

**[Table 3]**

| | | 180° peeling strength (N/cm) | | | | Result of cross-hatch test | | | |
|---|---|---|---|---|---|---|---|---|---|
| | | Initial | 25 hrs | 50 hrs | 75 hrs | Initial | 25 hrs | 50 hrs | 75 hrs |
| Example | 1 | Coat-T | Coat-T | Coat-T | Coat-T | 5B | 5B | 5B | 5B |
| | 2 | Coat-T | Coat-T | Coat-T | Coat-T | 5B | 5B | 5B | 5B |
| | 3 | Coat-T | Coat-T | Coat-T | Coat-T | 5B | 5B | 5B | 5B |
| | 4 | Coat-T | Coat-T | Coat-T | Coat-T | 5B | 5B | 5B | 5B |
| | 5 | Coat-T | Coat-T | Coat-T | Coat-T | 5B | 5B | 5B | 5B |
| | 6 | Coat-T | Coat-T | Coat-T | Coat-T | 5B | 5B | 5B | 5B |
| | 7 | Coat-T | Coat-T | Coat-T | Coat-T | 5B | 5B | 5B | 5B |
| | 8 | Coat-T | Coat-T | Coat-T | Coat-T | 5B | 5B | 5B | 5B |
| | 9 | Coat-T | Coat-T | Coat-T | Coat-T | 5B | 5B | 5B | 3B |
| | 10 | Coat-T | Coat-T | Coat-T | Coat-T | 5B | 5B | 5B | 5B |
| | 11 | Coat-T | Coat-T | Coat-T | Coat-T | 5B | 5B | 5B | 3B |
| Comparative Example | 1 | PVF-T | PVF-T | PVF-T | 0 | 5B | 5B | 5B | 0B |
| | 2 | 6.7 | 4.4 | 1.4 | 0 | 5B | 5B | 5B | 0B |
| | 3 | 0 | 0 | 0 | 0 | 0B | 0B | 0B | 0B |
| Coat-T: when measurement of exact peel strength was impossible because a resin layer was torn when peeling | | | | | | | | | |
| PVF-T: when measurement of exact peel strength was impossible because a PVF film was torn when peeling | | | | | | | | | |

As shown in Table 3, in the multilayered film in Example according to exemplary embodiments of the present application, the resin layer including a fluoropolymer had a high initial adhesive strength to the base (PET) through the primer layer including a fluoropolymer and an oxazoline group-containing acrylic polymer, and also had excellent adhesive strength after 75 hours of the PCT. In addition, after 75 hours of the PCT, changes in exterior such as an interface peeling and generation of pinholes were not observed from the primer layer and the resin layer. Meanwhile, it was confirmed that the commercially available multilayered films such as Icosolar 2442 and 3469 (Comparative Examples I and 2) were dramatically decreased in adhesive strength to the base as the PCT progressed. In addition, when the resin layer including a fluoropolymer was directly formed without forming a primer layer including a fluoropolymer and an oxazoline group-containing polymer on a base (Comparative Example 3), compared with Examples, it had poor adhesion reliability.

A multilayered film according to exemplary embodiments of the present application includes a primer layer including a fluoropolymer and an oxazoline group-containing polymer between a base and a resin layer including a fluoropolymer, and thus a chemical bond between the oxazoline group-containing polymer and the base and inter-diffusion between the fluoropolymer of the primer layer and the resin layer including a fluoropolymer formed on the primer layer are maximized. As a result, a multilayered film having excellent reliability and adhesive strength under heat/moisture resistance conditions, and excellent weather resistance and durability can be provided. In addition, the multilayered film according to exemplary embodiments of the present application can be manufactured with a low cost at a low drying temperature using a low boiling point solvent, and thus production costs may be reduced. Such a multilayered film can be useful for a backsheet for a photovoltaic module to provide a photovoltaic module which can maintain excellent durability even in long-term exposure to an external environment.

While the invention has been shown and described with reference to certain exemplary embodiments thereof, it will be understood by those skilled in the art that various changes in form and details may be made therein without departing from the scope of the invention as defined by the appended claims.

## Claims

1. A multilayered film, comprising:
a base;
a primer layer which includes a fluoropolymer and an oxazoline group-containing polymer and which is formed on the base; and
a resin layer which includes a fluoropolymer and which is formed on the primer layer.

2. The film according to claim 1, wherein the base is a metal film or polymer film.

3. The film according to claim 2, wherein the polymer film is at least one selected from the group consisting of an acryl film, a polyolefin film, a polyamide film, polyurethane film, a polyethyleneterephthalate (PET) film, a polyethylenenaphthalate (PEN) film, and a polybutyleneterephthalate (PBT) film.

4. The film according to claim 1, wherein at least one surface of the base is subjected to at least one surface treatment selected from the group consisting of treatments with plasma, corona, a primer, an anchor agent, and a coupling agent and thermal treatment.

5. The film according to claim 1, wherein an inorganic oxide deposition layer is formed on one or both surfaces of the base.

6. The film according to claim 1, wherein the base has a thickness of 50 to 500 µm.

7. The film according to claim 1, wherein the oxazoline group-containing polymer of the primer layer is a homopolymer of an oxazoline group-containing monomer, a copolymer including an oxazoline group-containing monomer and at least one comonomer, or a mixture thereof.

8. The film according to claim 7, wherein the oxazoline group-containing monomer is a compound represented by Formula 1: 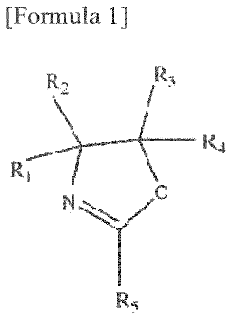 where R₁, R₂, R₃, and R₄ represent each independently a hydrogen atom, an alkyl group, a halogen, or a substituted or unsubstituted phenyl group, and R₅ represents a non-cyclic hydrocarbon group having an unsaturated bond.

9. The film according to claim 7, wherein the oxazoline group-containing monomer is at least one selected from the group consisting of 2-vinyl-2-oxazoline, 2-vinyl-4-methyl-2-oxazoline, 2-vinyl-5-methyl-2-oxazoline, 2-isoprophenyl-2-oxazoline, 2-isoprophenyl-4-methyl-2-oxazoline, and 2-isoprophenyl-5-ethyl-2-oxazoline.

10. The film according to claim 7, wherein a content of the oxazoline group-containing monomer included in the copolymer is 1 wt% or more with respect to a total weight of the copolymer including an oxazoline group-containing monomer and at least one comonomer.

11. The film according to claim 10, wherein a content of the oxazoline group-containing monomer included in the copolymer is 5 to 95 wt% with respect to a total weight of the copolymer including an oxazoline group-containing monomer and at least one comonomer.

12. The film according to claim 7, wherein the comonomer included in the copolymer is at least one selected from the group consisting of an alkyl (meth)acrylate, an amide group-containing monomer, an unsaturated nitrile-based monomer, a vinyl ester-based monomer, a vinyl ether-based monomer, a halogen-containing α,β-unsaturated monomer, and an α,β-unsaturated aromatic monomer.

13. The film according to claim 12, wherein the alkyl(meth)acrylate is at least one selected from the group consisting of methyl(meth)acrylate, ethyl(meth)acrylate, propyl(meth)acrylate, n-butyl(meth)acrylate, s-butyl(meth)acrylate, t-butyl(meth)acrylate, isobutyl(meth)acrylate, hexyl(meth)acrylate, 2-ethylhexyl(meth)acrylate, n-octyl(meth)acrylate, isooctyl(meth)acrylate, n-nonyl(meth)acrylate, isononyl(meth)acrylate, n-decyl(meth)acrylate, isodecyl(meth)acrylate, n-dodecyl(meth)acrylate, n-tridecyl(meth)acrylate, and n-tetradecyl(meth)acrylate.

14. The film according to claim 1, wherein the oxazoline group-containing polymer has a weight average molecular weight of 5,000 to 500,000.

15. The film according to claim 1, wherein a content of the oxazoline group-containing polymer of the primer layer is 5 to 100 parts by weight with respect to 100 parts by weight of a fluoropolymer of the primer layer.

16. The film according to claim 1, wherein the fluoropolymer is a homopolymer, copolymer, or mixture thereof including at least one monomer selected from the group consisting of vinylidene fluoride (VDF), vinyl fluoride (VF), tetrafluoroethylene (TFE), hexafluoropropylene (HFP), chlorotrifluoroethylene (CTFE), trifluoroethylene, hexafluoroisobutylene, perfluorobutylethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxole (PDD), and perfluoro-2-methylene-4-methyl-1,3-dioxolane (PMD) in a polymerized form.

17. The film according to claim 1, wherein the fluoropolymer is a copolymer including vinylidene fluoride (VDF) or vinyl fluoride (VF), and at least one comonomer selected from the group consisting of tetrafluoroethylene (TFE), hexafluoropropylene (HFP), chlorotrifluoroethylene (CTFE), trifluoroethylene, hexafluoroisobutylene, perfluorobutylethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxol (PDD), and perfluoro-2-methylene-4-methyl-1,3-dioxolane (PMD), or a mixture thereof.

18. The film according to claim 17, wherein a content of the comonomer included in the fluorine-based copolymer is 0.5 to 50 wt% with respect to a total weight of the fluorine-based copolymer.

19. The film according to claim 1, wherein the fluoropolymer includes i) a first fluoropolymer having a melting point of 155 °C or less or a softening point of 100 °C or more, and selectively further includes ii) a second fluoropolymer having a melting point of 155°C or more and a softening point of 100 °C or less.

20. The film according to claim 19, wherein a content of the first fluoropolymer having a melting point of 155 °C or less or a softening point of 100 °C or more is 20 wt% or more with respect to a total fluoropolymer.

21. The film according to claim 1, wherein the fluoropolymer has a weight average molecular weight of 50,000 to 1,000,000.

22. The film according to claim 1, wherein the primer layer has a thickness of 10 nm or more.

23. The film according to claim 1, wherein the resin layer has a thickness of 3 to 50 µm.

24. The film according to claim 1, wherein the resin layer further includes at least one additive selected from the group consisting of a pigment, a filler, a UV stabilizer, a thermal stabilizer, and a barrier particle.

25. A method of manufacturing a multilayered film, comprising:
forming a primer layer including a fluoropolymer and an oxazoline group-containing polymer on a base; and
forming a resin layer including a fluoropolymer on the primer layer.

26. The method according to claim 25, wherein the forming of a primer layer including a fluoropolymer and an oxazoline group-containing polymer is performed by coating a resin composition for forming a primer layer including a fluoropolymer, an oxazoline group-containing polymer, and a solvent on a base.

27. The method according to claim 25, further comprising:
performing at least one surface treatment selected from the group consisting of plasma treatment, corona treatment, primer treatment, treatment with an anchor agent, treatment with a coupling agent, deposition treatment, and thermal treatment on one or both surfaces of the base before forming the primer layer.

28. The method according to claim 26, further comprising:
performing a drying process after coating a resin composition for forming a primer layer including a fluoropolymer and an oxazoline group-containing polymer on the base.

29. The method according to claim 28, wherein the drying of the primer layer is performed at 200 °C or less for 30 seconds to 30 minutes.

30. The method according to claim 25, wherein the forming of a resin layer including a fluoropolymer is performed by coating a resin composition for forming a resin layer including a fluoropolymer and a solvent having a boiling point of 200 °C or less on the primer layer.

31. The method according to claim 30, wherein the solvent having a boiling point of 200 °C or less is at least one selected from the group consisting of acetone, methylethylketone, dimethylformamide, and dimethylacetamide.

32. The method according to claim 30, further comprising:
performing a drying process after coating a resin composition for forming a resin layer on the primer layer.

33. The method according to claim 32, wherein the drying of the primer layer is performed at 200 °C or less for 30 seconds to 30 minutes.

34. A backsheet for a photovoltaic module comprising the multilayered film according to any one of claims 1 to 24.

35. A photovoltaic module comprising the backsheet for a photovoltaic module according to claim 34.
